Europäisches Patentamt

European Patent Office

Office européen des brevets

(11) Publication number: **0 139 470**
**A2**

## (12) EUROPEAN PATENT APPLICATION

(21) Application number: **84306297.7**

(22) Date of filing: **14.09.84**

(51) Int. Cl.⁴: **H 04 N 5/52**
**H 03 G 3/30**

(30) Priority: **15.09.83 GB 8324697**

(43) Date of publication of application:
**02.05.85 Bulletin 85/18**

(84) Designated Contracting States:
**AT BE CH DE FR IT LI LU NL SE**

(71) Applicant: SINCLAIR RESEARCH LIMITED
25 Willis Road
Cambridge CB1 2AQ(GB)

(72) Inventor: Hoodless, Adrian Harry William
Dibden Moor End Road
Radwell Bedford MK43 7HY(GB)

(72) Inventor: Westwood, James St. Valentine
9 Landbeach Road
Milton Cambridge(GB)

(72) Inventor: Neale, Michael William
7 Brookhampton Street
Ickleton Cambridgeshire CB10 15P(GB)

(74) Representative: Pike, Harold John et al,
Abel & Imray Northumberland House 303-306 High
Holborn
London, WC1V 7LH(GB)

(54) Improvements in or relating to television receivers.

(57) A television receiver amplifier particularly suitable for fabrication as an integrated circuit. The amplifier configuration is such that only integrated circuit components are required to provide a fully functional television receiver signal processing amplifier.

A signal detector and a d.c. level restoring circuit having circuit configuration which permit the fabrication of fully functional units using only integrated circuit components, are described also

EP 0 139 470 A2

./...

Croydon Printing Company Ltd.

Fig. 2a.

Fig. 2b.

0139470

## Improvements in or relating to television receivers

This invention relates to television receivers.

Small, portable, battery-operated television receivers have been manufactured in the past but only recently has it become practicable to construct such receivers which are sufficiently small to be carried in a pocket, with the production of flat, cathode ray display tubes and other compact display devices. A disadvantage with a portable, battery-operated television receiver is that large batteries are heavy and are consequently undesirable, and lighter, smaller batteries do not have a large capacity, so that they have a short useful life and have to be replaced frequently, with an attendant cost penalty. It is therefore essential in such a receiver to keep the current consumption as low as possible. Partly for this reason and partly because of limitations of space it is desirable to include as many of the circuits of the receiver as conveniently possible in a single integrated circuit or possibly a few integrated circuits. A difficulty in the use of integrated circuits for processing signal waveforms such as are employed in television receivers arises because of the variations in the characteristics and the non-ideal behaviour of the elements of the circuits which need correction and/or compensation for acceptable performance.

Another problem with battery-operated receivers is that the voltage produced by the battery falls during its useful life, so that regulation of the voltage is desirable for maintaining the required relationships between the various signals employed in producing the display, which otherwise could become distorted. Such regulation is, however, undesirable because of the power which it consumes.

It is therefore an object of the present invention to overcome one or more of the difficulties outlined above. It should, nevertheless, be borne in mind that the invention is applicable to any type of television receiver and not merely to portable, battery-operated ones.

Resolution of the difficulties encountered in the design of a highly portable television receiver leads to circuit arrangements which represent considerable departures from established practice. Such circuit arrangements are of course, particularly, suited to implementation in integrated circuit form but are not necessarily so limited.

The present invention provides a bandpass amplifier the gain of which is controllable by varying the emitter current in a transistor of a stage of the amplifier.

Preferably the stage in which the emitter current of a transistor is variable is the input stage, and, additionally, the emitter current of a transistor of a subsequent stage, preferably the second stage, may also be variable.

In practice, a bandpass amplifier the gain of which is controllable by varying the emitter current of a transistor of a stage may include a plurality of stages separated from each other by buffer stages, preferably emitter follower buffer stages, and, preferably, variation of the emitter current of the or each transistor is effected by means of a voltage-controllable current source or current sink.

In the operation of a bandpass amplifier, in accordance with the invention, the gain would, advantageously, be controlled by means of an automatic gain control system associated with the amplifier.

The present invention provides also a bandpass amplifier in which passband shaping is effected by means of at least one emitter load capacitor.

In practice, bandshaping may be effected by means of an arrangement whereby an emitter load capacitor is associated with each of a plurality of stages of the bandpass amplifier.

Preferably, the arrangement is such that a plurality of stages of the amplifier employ bipolar transistors with emitters loaded by respective current sources and respective emitter load capacitors are connected in the emitter circuits of the transistors.

Advantageously, the function of the emitter load capacitor is performed by a back-biassed diode.

The present invention provides also a detector for an amplitude-modulated signal, the detector including a plurality of non-linear stages so arranged as to provide substantially linear overall characteristics.

Preferably the non-linear stages include a plurality of bipolar transistors arranged to operate in low-level non-linear states.

In practice, the detector may include an input stage arranged to produce a current dependent on the square of the amplitude of an amplitude-modulated input signal, and a further stage arranged to provide a voltage which is dependent on the square root of the current, the voltage being an amplified replica of the modulation of the input signal.

The input stage may be so arranged as to generate, in response to an amplitude-modulated input signal, a current which has a constant component and a component dependent on the square of the modulation of the input signal, and to transfer to a following stage only the component dependent on the square of the modulation of the input signal.

Preferably, the detector includes a square law voltage to current converting input stage with cancellation of a constant current component, a current amplifying second stage, a third stage arranged to provide a current which is the square root of the current of the second stage, and an output stage arranged to provide a voltage dependent on the current of the third stage.

The present invention also provides a level setting circuit arrangement, suitable for d.c. level restoration in a television receiver, employing feedback in the voltage level stabilisation of a periodically occurring input signal.

In practice, a level setting circuit arrangement, in accordance with the present invention, may include voltage level setting means having a reference input level and which operates to clamp a periodically occurring input signal at a set level by sensing any difference between the upper or lower level of the input signal and the reference input level, and applying a correction at the receiving point of the input signal to adjust the

- 6 -

upper or lower level of the input signal at the set level.

The level setting means may include a comparator arranged to respond to the reference level and to the upper or lower level of the input signal and to generate a correction value.

Advantageously, the level setting circuit arrangement is such as to provide an offset voltage between the reference level and the upper or lower level of the input signal, and, preferably, the offset voltage is provided by a forward biassed semiconductor diode.

A bandpass amplifier, a detector, and a level setting circuit arrangement, in accordance with the various aspects of the present invention will now be described by way of example only and with reference to the accompanying drawings, in which:-

Fig. 1 is a circuit diagram representation of a television receiver including an integrated circuit embodying various aspects of the present invention,

Fig. 2 is a block diagram representation of the integrated circuit included in Fig. 1,

Fig. 3 is a part block diagram representation of the integrated circuit of Fig. 1 showing an I.F. amplifier, a detector, and a d.c. restorer,

Fig. 4 is a circuit diagram representation of the I.F. amplifier of Fig. 3,

Fig. 5 is a circuit diagram representation of the detector of Fig. 3, and,

Fig. 6 is a circuit diagram representation of the d.c. restorer of Fig. 3.

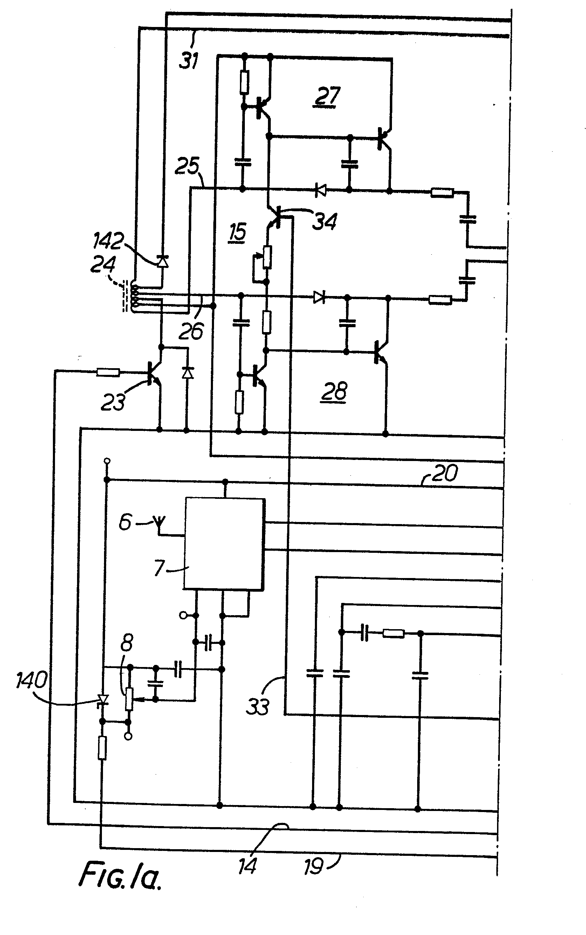

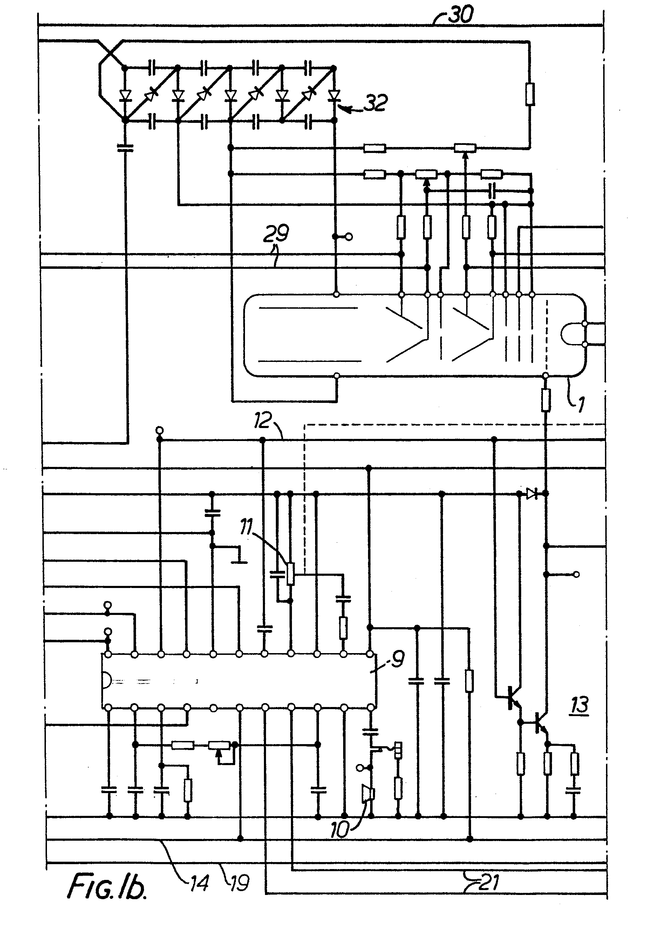

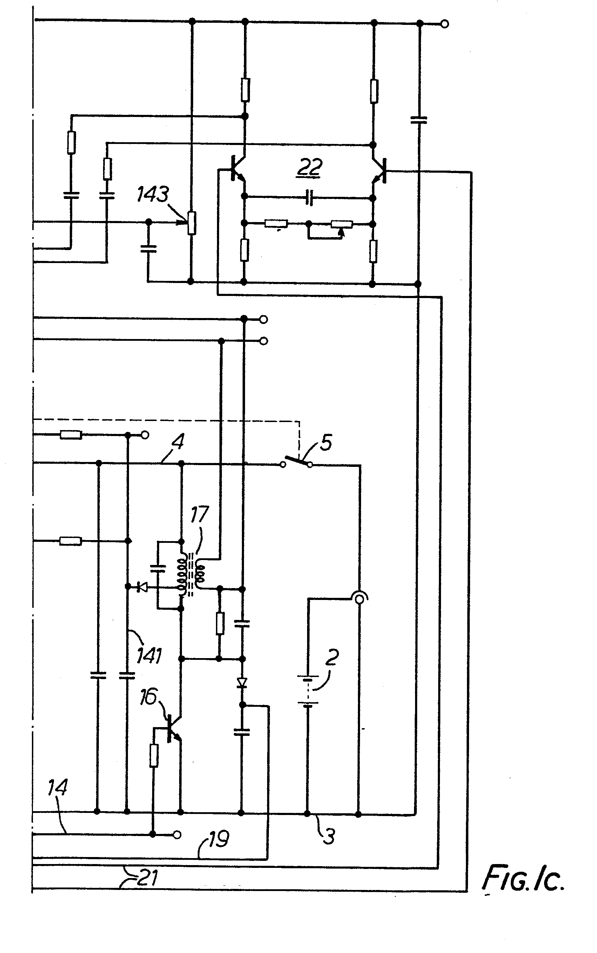

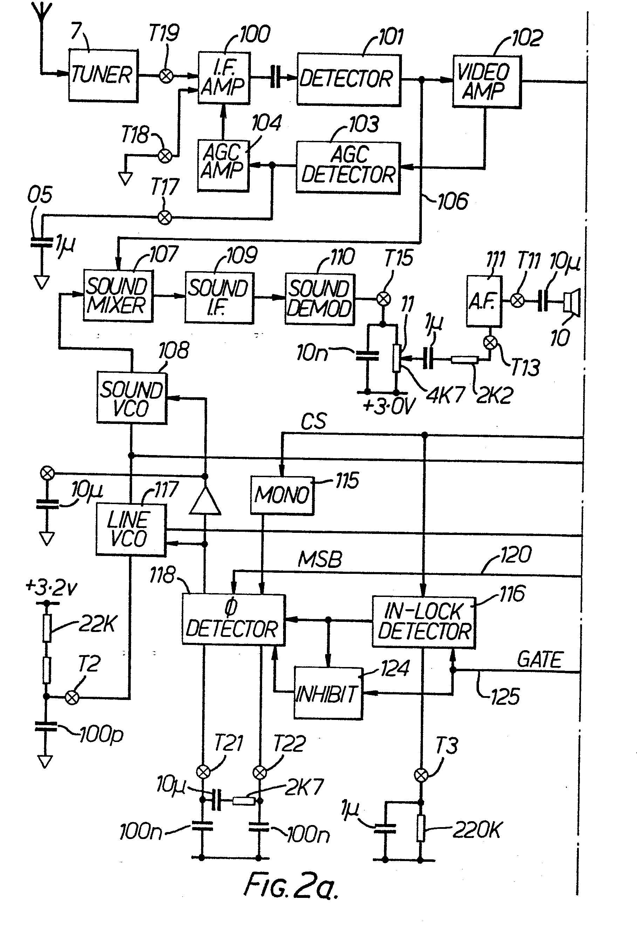

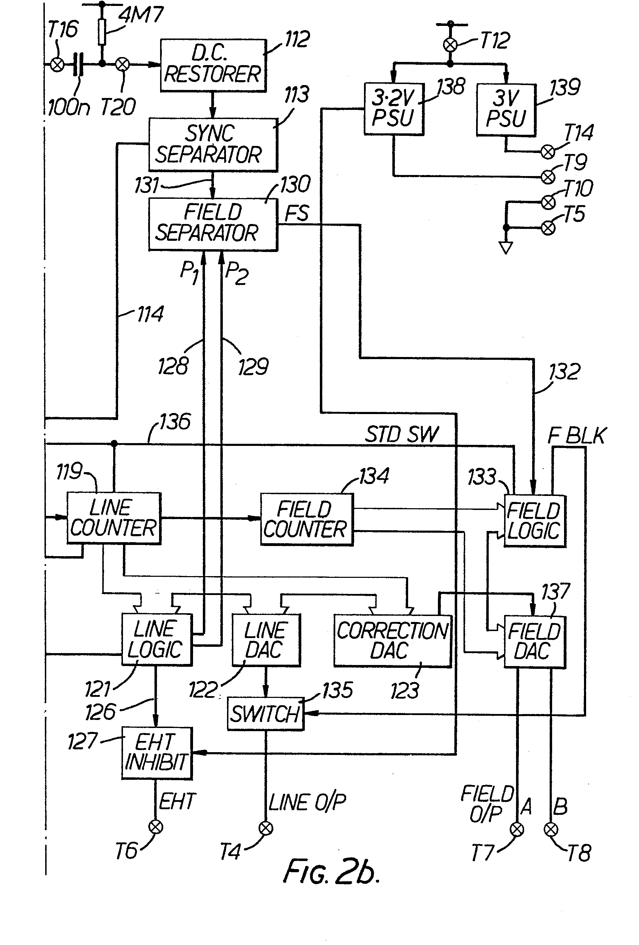

Figure 1 shows the circuit diagram of one example of a television receiver using the invention. The receiver has a flat electrostatically focussed and deflected cathode ray display tube 1 of the type described in British Patent Specification No. 1 592 571. The receiver is powered by a battery 2 providing 6 volts. The battery 2 is connected between an earthed conductor 3 and a supply conductor 4 to which it is connected by an on/off switch 5. The television signals are picked up by an aerial 6 which is connected to a tuner unit 7 which may be of conventional construction. The tuning of the unit 7 is effected by means of one or more varactor diodes to which an adjustable DC voltage is applied from a tuning potentiometer 8. The intermediate frequency output signal from the tuner unit 7 is applied to an integrated circuit 9, the details of which are shown in block diagrammatic form in Figure 2 and which contains the video and sound intermediate frequency, signal separation and processing circuits, detector and amplifier stages together with the sync signal separator and the line and field scanning oscillators. The sound output signal is reproduced by a loudspeaker 10, the volume of which is controlled by a potentiometer 11. The video output signal from the integrated circuit 9 is conveyed by a conductor 12 to a further video amplifier 13 consisting of two transistor stages, the output of which is connected to the grid of the cathode ray tube 1. The line scan signals are applied via a conductor 14 to the line scanning circuit 15 and also to a transistor 16 which operates as a switch to interrupt the DC supply to the primary of a transformer 17 which feeds pulses to produce a 15 volt supply for the video circuits on the line 12. The secondary winding of the transformer 17 supplies the energisation for the heater of the cathode ray tube 1 and this is connected to the collector of the transistor 16 so that the positive-going pulses serve to blank the spot during line flyback. From the collector of the transistor 16 a supply voltage is derived which is established on a conductor 19 and is used to provide the tuning voltage of the tuner 7 via the potentiometer 8. A supply of 3 volts is set up on a supply conductor 20 by a part of the integrated circuit 9 to power the tuner 7. The field scan signal for the cathode ray tube 1 is supplied by the integrated circuit 9 via conductors 21 which are connected through a field scan amplifier 22 to the field scan electrodes of the cathode ray tube 1.

The line scanning circuit 15 receives the line drive signal supplied via the conductor 14 at the base of a transistor 23 which switches current through an autotransformer 24. Two outputs from the autotransformer 24 on conductors 25 and 26 supply similar pulses of opposite polarities to switched integrators 27 and 28 respectively which generate saw-tooth waveforms with flybacks caused by the pulses on the conductors 25 and 26, the saw-tooth waveforms being conveyed via conductors 29 to the line signal deflection electrodes of the cathode ray tube 1. The autotransformer 24 also supplies high voltage pulses along a conductor 30 to supply the field amplifier 22 and further high voltage pulses on a conductor 31 for driving a diode - capacitor stack 32 which generates the various EHT voltages for the cathode ray tube 1. A further output from the integrated circuit 9 is fed along a conductor 33 to control the conductivity of a transistor 34 which determines the slopes of the flanks of the saw-teeth by regulating the current

- 10 -

fed to the integrators.  This control is required because the cathode ray tube 1 is a flat tube with the screen end on to the electron gun.

Figure 2 shows a block diagram of the circuits contained in the integrated circuit 9 of Figure 1, and in Figure 2 the numbered terminals of the integrated circuit package are preceded by the letter T so that the first terminal is T1 and the last is T22.  The output of the tuner 7 (Figure 1) is connected via terminal T19 to an intermediate frequency amplifier 100.  The amplified output from the IF amplifier 100 is applied to a detector 101 and from that through a video amplifier 102 to the terminal T16.  An AGC signal for the amplifier 100 is derived from the amplifier 102 by an AGC detector 103 from which the AGC signal amplified by amplifier 104 is applied to control the gain of the amplifier 100. A capacitor 105 external to the integrated circuit is connected via terminal T17 to the output of the detector 103 to smooth the gain control voltage. The intercarrier sound is picked off from the output of the video detector 101 and applied via a conductor 106 to a sound channel mixer 107.  The oscillation from a local oscillator 108 is mixed with the sound signal from the output of the

- $1_1$ -

detector 101 to produce the required intermediate frequency signal which is amplified by IF amplifier 109, the amplified output of which is applied to a demodulator circuit 101 connected to apply the sound output signal to terminal T15. The potentiometer 11 serves as a volume control and regulates the amplitude of the audio signal reapplied to the integrated circuit at terminal T13 for amplification in the AF amplifier 111. The output audio signal is fed via the terminal T11 and a capacitor to the loudspeaker 10.

The video output signal from the amplifier 102 which appears at the terminal T16 is applied as described above with reference to Figure 1 to the grid of the cathode ray display tube 1. It is also reapplied to the integrated circuit via terminal T20 from which it is applied via a DC restoration circuit 112 to a sync separator circuit 113. Pulses at line frequency are conveyed by a conductor 114 to a monostable multivibrator 115 and an IN LOCK detector 116. A picture element frequency oscillator 117 which has its frequency controlled by the output of a phase detector 118 applies pulses to a counter 119 of which the most significant bit output is fed via a conductor 120 to an input of the phase detector 118 which compares the time of arrival of the most significant bit with the output of the monostable 115. The output of the phase detector 118 also controls the frequency of the local oscillator 108. When operating correctly the frequency of occurrence of the most significant bit signals on the conductor 120 will be at line frequency. The digital output of the counter 119 is applied to a line logic circuit 121, a line digital to analogue converter 122 and a correction digital to analogue converter 123. The line logic circuit 121 produces a gate signal which is applied to the phase detector 118 through an INHIBIT circuit 124 for limiting the time period over which the phase detector 118 is effective near each most significant bit output from the counter 119. The IN LOCK detector circuit 116 compares the timing of the line frequency pulses on the conductor 114 with the gate signals from the line logic circuit 121 on conductor 125 and is connected to the INHIBIT circuit 124 to prevent the gate signals from being applied to the phase detector 118 unless the output of the line counter 119 is substantially synchronised with the signals from the monostable 115. The line logic circuit 121 output on the conductor 125 is

- 13 -

also applied to the INHIBIT circuit 124. The line logic circuit 121 produces another output on the conductor 126 which is applied to an EHT INHIBIT circuit 127 connected to terminal T6 of the integrated circuit. This part of the circuit functions to inhibit the generation of pulses at line frequency at the terminal T6 when the voltage of the battery 2 falls below 4.3 volts to prevent the display of a distorted picture. The digital to analogue converter 122 produces line deflection rate controlling waveforms for controlling the integrators 27 and 28 (Figure 1) which generate the line scan waveforms and needed because of the geometry of the cathode ray tube 1. The purpose and operation of the digital to analogue converter 123 will be described later. The line logic circuit 121 also produces signals P1 and P2 identifying the odd and even fields on conductors 128 and 129 which are applied to a field separator circuit 130 which receives the field frequency pulses from the sync separator 113 via a conductor 131. The field sync pulses from the separator 130 are applied via a conductor 132 to a field logic circuit 133 which receives the digital output from a field counter 134 driven by pulses from the counter 119. Blanking signals

- 1₄ -

from the field logic circuit 133 are fed to a switch 135 to ground the terminal T4 and thereby hold the cathode ray tube spot at the left-hand side of the frame during field flyback. The field logic circuit 133 also produces line number standard switch output which is conveyed via a conductor 136 to the oscillators 108 and 117 and to the line counter 119 to enable the receiver to handle different television standards. The digital outputs from the field counter 134 are also applied to a field digital to analogue converter 137 which produces field scan drive signals on terminals T7 and T8. The output of the correction digital to analogue converter 123 is applied as the reference voltage for the converter 137. This correction is needed because the cathode ray tube 1 is a flat tube in which the screen lies end on to the electron gun. It will be appreciated that with a tube of this type if the field deflection voltage is kept constant whilst the line deflection voltage is varied to generate a line, the resulting picture would be trapezoidal in shape. In order to produce a rectangular picture, it is necessary to adjust the field deflection voltage as a line is described by the spot and the purpose of the converter 123 is to cause the field deflection voltage output of the field digital to analogue converter 137 to be adjusted according to the position of the spot along the line so as to produce a rectangular picture. The integrated circuit 9 also includes a 3.2 volt power supply 138 and a 3 volt power supply 139 energised from the main battery supply line 4 via terminal T12. The 3.2 volt supply is connected internally to the EHT INHIBIT circuit 127 and to the terminal T9. The 3 volt supply is connected just to the terminal T14. Earth connections are provided at terminals T5 and T10 and terminals T1, T3, T21 and T22 are provided for the connection of relatively large capacitances to the circuit.

It is not proposed to enter into a detailed description of the generation of the scanning signals and the operation of the circuits directly associated with this because these form the subject of other copending patent applications. The operation of the parts of the integrated circuit is otherwise fairly conventional for a television receiver, but where the circuit departs from the usual it will either be described later on in the present patent application or in another co-pending patent application.

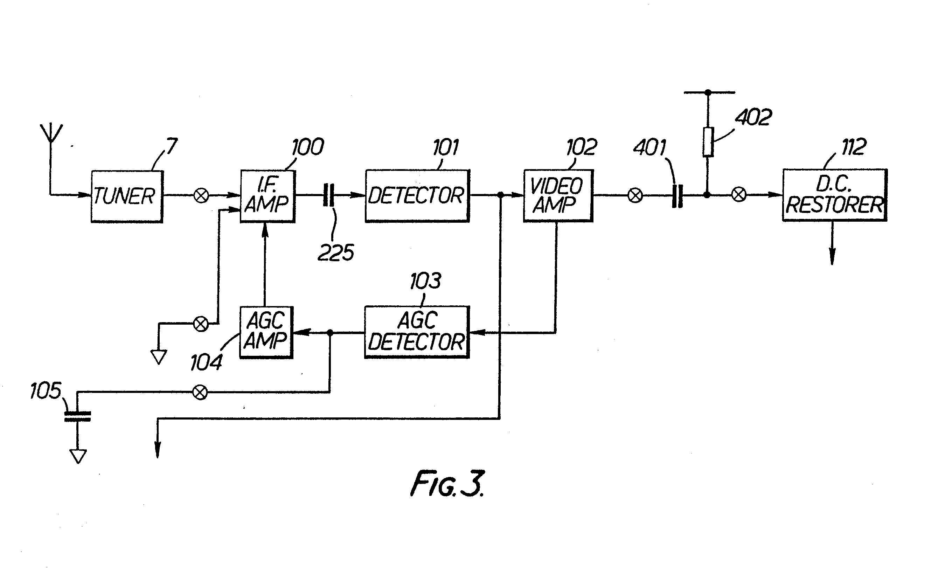

Referring now to Fig. 3, the signal-input circuit blocks of a television receiver system, which incorporates the present invention, includes a tuner 7, an I.F. amplifier 100, a detector circuit 101, a video amplifier 102, an automatic gain control (AGC) detector 103, an AGC amplifier 104, and a level restoration circuit 112.

As is usual for the operation of this part of a television receiver system, a signal from a television transmitter is received by an aerial to which the tuner 7 is connected, and the tuner 7 frequency shifts the received signal to the I.F. and passes the I.F. signal to the I.F. amplifier 100, the I.F. amplifier 100 providing gain and bandshaping and then passing the I.F. signal to the detector 101 by way of a coupling capacitor 401. The detector 101 recovers the information signal, which is the television video signal, and supplies the video signal to a display device (usually a cathode ray tube). The video signal is also processed by the AGC detector 101 which provides a d.c. level corresponding to the video signal amplitude. The d.c. level output of the AGC detector 101 is smoothed by a capacitor 8, amplified by the AGC amplifier 6 and is applied to the I.F. amplifier 105 in such a manner as to stabilise the amplitude of the I.F. output signal from the I.F. amplifier 100. The video signal passes also, by way of a capacitor 401, to a level restorer 112 which, in association with a leak resistor 402, establishes a desired direct voltage level for the signal.

The tuner 7 is relatively conventional but departs from more established tuner practice in that it has an I.F. of 230 MHz.

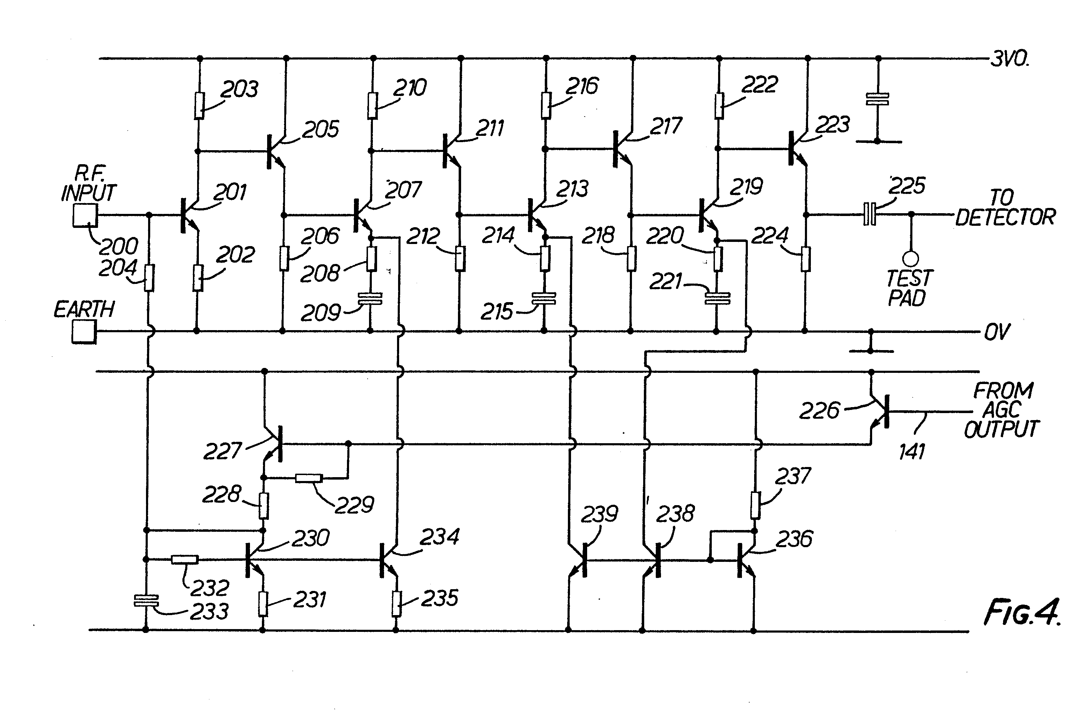

The I.F. amplifier 100 is shown in detail in Fig. 4 and includes the following sections:-

(i)  An input section, consisting of an NPN bipolar transistor 201 having respective emitter and collector load resistors 202 and 203, and a common collector NPN bipolar transistor 205 with an emitter resistor 206. The base electrode of the transistor 201 is the input port 200 of the I.F. amplifier. A resistor 204 connects the base electrode of the transistor 201 to a controllable current source which is used to vary the emitter current of the transistor 201. The controllable current source includes the NPN bipolar transistors 226 and 227 and their associated resistors 228 and 229.

- 18 -

A current mirror including NPN transistors 230 and 234, their associated resistors 231, 232 and 235, and a smoothing capacitor 233 provides a mirror current of that provided by the transistor 227.

(ii) a second section, consisting of an NPN bipolar transistor 207 having a collector resistor 210 and emitter components consisting of a resistor 208 and a capacitor 209, and a common collector NPN bipolar transistor 211 with an emitter resistor 212. The emitter electrode of the transistor 207 is connected to the current mirror which includes the NPN bipolar transistor 234.

(iii) a third section, having the same form as the second section, consisting of NPN bipolar transistors 213 and 217, the associated resistors 214, 216, and 218, and the associated capacitor 215. The emitter electrode of the transistor 213 is connected to a constant current sink which includes NPN bipolar transistors 236 and 239 with an associated resistor 237.

(iv) a fourth section, having the same form as the second section, consisting of NPN bipolar transistors 219 and 223, the associated resistors 220, 222 and 224, and the associated capacitor 221. The emitter electrode of the transistor 219 is connected to a constant current sink which includes an NPN bipolar transistor 238. The transistor 238 is controlled by the same current source as the transistor 239 of the third stage. The emitter electrode of the transistor 223 drives the output port 240 of the amplifier by way of a capacitor 225.

In the operation of the I.F. amplifier 100, an AGC voltage applied to the AGC input port 241 is converted into a corresponding current by the transistors 226 and 227. The resistors 228 and 229 perform the function of making the voltage-to-current conversion relatively linear. The current from the transistor 227 controls the emitter current, and thereby the gain, of the transistor 201. The current provided by the transistor 227 is mirrored by the current sink transistor 234 which controls the emitter current of the second section transistor 207. The transistors 201 and 207 are operated at a low level where gain increases with emitter current.

In the operation of the I.F. amplifier 100, the AGC voltage applied to the AGC input port 241 decreases as the signal applied to the signal input port 200 increases, and reduces the emitter current, and thereby the gain, of the transistor 207, in addition to reducing the emitter current, and thereby the gain, of the input section transistor 201.

Also, in the I.F. amplifier 100, the capacitor resistor combinations 208-209, 214-215, and 220-221, of the second, third, and fourth sections, respectively, provide overall bandpass shaping of the I.F. amplifier response as required.

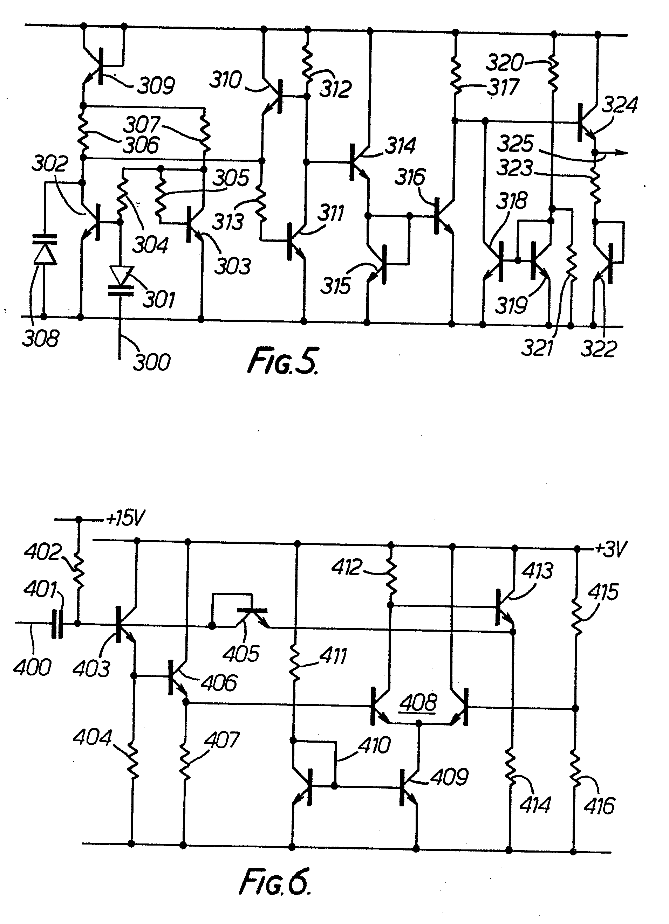

Referring now to Fig. 5, a detector suitable for demodulating a low-level amplitude-modulated signal includes an input stage having an input port 300, an input coupling diode-capacitor 301, an NPN bipolar transistor 302 the base electrode of which is connected to the diode-capacitor 301, a filter diode-capacitor 308 connected across the collector and emitter electrodes of the transistor 3-2, and a collector load resistor 306 for the transistor 302. The collector load resistor 306 is connected by way of a diode-connected transistor 309 to the positive side of a power supply. Connected in shunt with the transistor 302 and its collector load resistor 306 is the series combination of a transistor 303 and its collector load resistor 307, the collector electrode of the transistor 303 being connected firstly to its base by way of a resistor 305 and secondly to the base electrode of the transistor 302 by way of a resistor 304.

The collector electrode of the transistor 302 is connected to a second stage of the detector, the detector second stage including a transistor 310 with an emitter load resistor 313, the emitter load resistor 313 leading to the base electrode of a transistor 311 having its collector electrode connected to the base electrode of the transistor 310 and having a collector load resistor 312. There is a direct connection between the collector electrode of the transistor 302 and the emitter electrode of the transistor 310.

The collector electrode of the transistor 311 is connected to a third stage of the detector, the detector third stage including a transistor 314 having a diode-connected transistor 315 as an emitter load and no collector load. There is a direct connection between the collector electrode of the transistor 313 and the base electrode of the transistor 314.

The emitter electrode of the transistor 314 is connected to a fourth stage of the detector, the detector fourth stage including a transistor 316 having a collector load resistor 317 and no emitter load. The collector electrode of the transistor 316 is connected to a current sink in the form of a transistor 318 with its associated current-setting components consisting of a diode-connected transistor 319 connected between the base and emitter electrodes of the transistor 319 and which is connected in parallel with a resistor 321 of a resistive potential divider 320,321. There is a direct connection between the emitter electrode of the transistor 314 and the base electrode of the transistor 316.

The collector electrode of the transistor 316 is connected to a buffer output stage of the detector, the buffer output stage including a transistor 324 having a resistor 323 and a diode connected transistor 322 in series as its emitter load, and having no collector load. The collector electrode of the transistor 316 is connected directly to the base electrode of the transistor 324. The output signal from the buffer output stage appears at the emitter electrode of the transistor 324.

In the operation of the detector represented by Fig. 5, an amplitude-modulated input carrier with a modulating signal $\underline{S}$ applied to the input port 300 of the detector will give rise to a current of approximate value $\underline{1} + \dfrac{\underline{S}^2}{2}$ in the collector circuit of the transistor 302 and a current of value $\underline{1}$ will flow in the resistor 306 while a current of value $\dfrac{\underline{S}^2}{2}$ is drawn from the second stage (310 to 313). The second stage provides a current value $\underline{A}\underline{S}^2$ as an output current to the third stage, $\underline{A}$ being the current amplification factor of the second stage. The third stage (314, 315) assisted by the base-emitter diode of the transistor 316 provides a collector current for the transistor 316 which is the square root of the current received from the second stage (310 to 313) and the collector load resistor 317 of the the transistor 316 converts the transistor current to a voltage proportional to $\underline{S}$. In this way, the modulating signal $\underline{S}$ is recovered from the amplitude-modulated carrier.

The detector represented by Fig. 5 is particularly suited to the demodulation of low-level signals which will cause the input transistor 302 to operate on the highly curved part of its characteristic. The detector represented by Fig.

5 is able to produce a linear output from a low-level input signal by exploiting fully the nonlinearities of transistors. In the detector represented by Fig. 5, a current is generated which has a square-law relationship to a modulating input signal amplitude, the current is amplified, the square root of the amplified current is generated, and an amplified replica of the modulating input signal is generated from the square root of the amplified current.

The detector represented by Fig. 5 is particularly suited to implementation in integrated circuit form.

Referring to Fig. 6, a voltage level restoration or setting circuit has an input port 400 formed by one plate of a capacitor 401, the other plate of the capacitor 401 being connected to the base electrode of a transistor 403 which has a base bias resistor 402 connected to a positive terminal of a 15 volt power supply. The transistor 403 has an emitter load resistor 404 and the collector electrode of the transistor is connected directly to the positive terminal of a 3 volt power supply. The base electrode of the transistor 403 is connected also to the anode electrode of a diode-connected transistor 405 the cathode electrode of which is connected to the emitter electrode of a transistor 413, the collector electrode of the transistor 413 being connected to the positive terminal of the 3 volt supply and there being an emitter load resistor 414 for the transistor 413. The base electrode of the transistor 413 is connected to the collector electrode of the left-hand transistor of an emitter-coupled pair of transistors 408 the left-hand transistor of which has a collector load resistor 412 and the right-hand transistor of which has no collector load resistor. The base electrode of the right-hand transistor of the emitter-coupled pair 408 is biassed by a resistive potential divider consisting of two resistors 415 and 416 while the base electrode of the left-hand transistor of the emitter-coupled pair 408 is connected to the emitter electrode of a transistor 406 the base electrode of which is connected to the emitter electrode of the transistor 403. The transistor 406 has an emitter load resistor 407. The emitters of the emitter-coupled transistor pair 408 are connected to a current-source transistor 409 which is controlled by a resistor 411 and a diode-connected transistor 410. The components 403 to 416 are supplied with power from the 3 volt supply.

In the voltage level setting system of Fig. 6, the voltage divider chain consisting of resistors 415 and 416 set the voltage level at the base electrode of the right-hand transistor of the emitter-coupled pair 408. The current-source transistor 409 sets a value for the total current for the emitter-coupled transistor pair.

The voltage at the base of the left-hand transistor of the emitter-coupled transistor pair 408 will control the amount of current flowing through the resistor 412 and thereby the voltage level at emitter electrode of the transistor 413. The voltage at the emitter electrode of the transistor 413 is communicated, by way of the diode-connected transistor 405, to the base electrode of the transistor 403 which controls the voltage level at the emitter electrode of the transistor 406, the base electrode of the left-hand transistor of the emitter-coupled pair 408 being connected to the emitter electrode of the transistor 406 to form part of a closed loop. The voltage level at the base electrode of the transistor 403 is therefore related to the values of the resistors 415 and 416 and the circuit will operate to oppose a rise of the voltage at the base electrode of the transistor 403 but will permit the voltage to fall below the set level. The correction loop has gain and will therefore respond to a smaller rise in the input signal than will more conventional voltage level setting systems.

In the voltage level setting system of Fig. 6, the resistors 415 and 416 may have such values as to set a level of about 1.1 volts at the base of the right-hand transistor of the transistor pair 408. When the system establishes balance in the transistor pair 408 the base electrode of the left-hand transistor of the transistor pair 408 will then be at about 1.1 volts also and the voltage level at the base electrode of the transistor 403 will be about 2.5 volts on the basis that each of the transistors 403 and 406 has a base-emitter voltage offset of about .7 volts. The system could be operated from a single voltage supply exceeding 3 volts but there will be a penalty of increased energy dissipation. The part of the system shown as operating from a 3 volt supply is particularly suited to implementation in integrated circuit form.

- 28 -

The voltage level setting system shown in Fig. 6 may be applied to the d.c. level restoration of the synchronising pulses in a television receiver with the advantage that there is less synchronising pulse level loss than with previously known d.c. level restoration arrangements.

In applying the system of Fig. 6 to synchronising pulse level restoration in a television receiver, a differential output may be obtained from the bases of the transistor pair 408 by means of a similarly configured transistor pair which could provide in-phase and anti-phase composite synchronising signals at a chosen level.

Claims:

1.    An amplifier the gain of which is controllable by varying the emitter current in a bipolar transistor amplifying stage, including a controllable current stage setting the emitter current of the transistor, an input port of the controllable current stage being a gain control port of the amplifier.

2.    An amplifier, as claimed in claim 1, including a first bipolar transistor amplifying stage, a first controllable current stage setting the emitter current of the first transistor, a second bipolar transistor amplifying stage, and a second controllable current stage setting the emitter current of the second transistor, wherein the currents provided by the first and second current stages are in a fixed ratio.

3.    An amplifier, as claimed in claim 1 or claim 2, including a controllable current source arranged to supply base current to a transistor.

4.    An amplifier, as claimed in claim 1, or claim 2, or claim 3, including a controllable current sink arranged to draw emitter current from a transistor.

5. An amplifier, as claimed in any one of claims 1 to 4, including additional bipolar transistor amplifying stages and respective additional current stages setting the emitter currents of the additional bipolar transistors.

6. An amplifier, as claimed in any one of claims 2 to 5, including emitter follower stages linking the amplifying stages in series.

7. An amplifier, as claimed in any one of claims 2 to 6, including series-connected capacitor and resistor means connected in parallel with at least one current stage to form a bandpass amplifier.

8. An amplifier, as claimed in claim 7, including an automatic gain control arrangement for controlling the controllable current stages to form an intermediate frequency amplifier.

9. An amplifier, as claimed in any one of claims 1 to 8, wherein each stage is directly coupled to an adjacent stage.

10. A bandpass amplifier including a transistor amplifying stage, a current stage setting the load current of the transistor, and series-connected capacitor and resistor means forming one input network of the transistor.

11. A bandpass amplifier, as claimed in claim 10, wherein the current stage is a current source arranged to supply base current to the transistor.

12. A bandpass amplifier as claimed in claim 10 or 11, including additional transistor amplifying stages, respective additional current stages setting the load currents of the transistors, and respective additional series-connected capacitor and resistor means forming input networks of the transistors.

13. A bandpass amplifier as claimed in claim 12, wherein each capacitor means is a diode capacitor.

14. A bandpass amplifier including a plurality of bipolar transistor amplifying stages, a plurality of current stages setting the emitter currents of the transistors, and a plurality of series-connected capacitor and resistor means forming emitter networks of the transistors, wherein at least one of the current stages is controllable by way of a gain control port of the amplifier.

15. A bandpass amplifier as claimed in any one of claims 12 to 14, wherein the current stages include current sinks.

16. A bandpass amplifier, as claimed in any one of claims 12 to 15, including emitter follower stages linking the amplifying stages in series.

17. A bandpass amplifier, as claimed in any one of claims 10 to 16, wherein each stage is directly coupled to an adjacent stage.

18. A detector for an amplitude-modulated signal including (i) a first non-linear stage which, when provided with an amplitude-modulated input signal, provides substantially a constant output signal and a distorted form of the modulating signal, (ii) a subsequent stage which removes the constant output signal, and, following the subsequent stage, (iii) a second non-linear stage which so changes the distorted form of the modulating signal as to provide a linear form of the modulating signal.

19. A detector for an amplitude-modulated signal, as claimed in claim 18, wherein the first non-linear stage provides a distorted form of a modulating signal which is the square of the modulating signal and the second non-linear stage provides the square root of a signal presented to it.

20.  A detector for an amplitude-modulated signal, as claimed in claim 18 or claim 19, wherein the first non-linear stage provides a current which has a constant component and a component dependent on the square of the modulation, the subsequent stage removes the constant component, and the second non-linear stage provides a current which is the square root of the component dependent on the square of the modulation.

21.  A detector for an amplitude-modulated signal, as claimed in any one of claims 18 to 20, wherein the non-linear stages include bipolar transistors operating in low-level non-linear states.

22.  A level setting circuit including amplifying means responsive to the departure of periodically recurrent parts of an input signal from a set level and means responsive to the output of the amplifying means to adjust the level of the input signal to stabilise the level of its periodically recurrent parts.

23. A level setting circuit, as claimed in claim 22, including an input circuit having a coupling capacitor, amplifying means connected to the input circuit and to a reference voltage source arranged to provide an output voltage dependent on the difference between the voltage at a point in the input circuit and the reference voltage, and, control means connecting an output of the amplifying means to the input circuit arranged to oppose variations of the voltage at a component of the input circuit relative to the reference voltage.

24. A level setting circuit, as claimed in claim 23, wherein the control means is arranged to adjust the voltage at one plate of the coupling capacitor in the input circuit.

25. A level setting circuit, as claimed in claim 23 or 24, wherein the amplifying means includes a differential stage having standing currents set by a constant current generator.

26. A television receiver including an amplifier as claimed in any one of claims 1 to 17.

27.    A television receiver including a detector for an amplitude-modulated signal as claimed in any one of claims 18 to 21.

28.    A television receiver including a level-setting circuit, for d.c. level setting, as claimed in any one of claims 22 to 25.

29.    An integrated circuit including an amplifier as claimed in any one of claims 1 to 17.

30.    An integrated circuit including a detector for an amplitude-modulated signal as claimed in any one of claims 18 to 21.

31.    An integrated circuit including a level-setting circuit, for d.c. level setting, as claimed in any one of claims 22 to 25.

Fig. la.

0139470

Fig.1b.

FIG. Ic.

4/8

FIG. 2a.

Fig. 2b.

FIG.3.

0139470

Fig.4.

Fig.5.

Fig.6.